# EUROPÄISCHE PATENTSCHRIFT

(11) **EP 1 719 193 B1**
(45) Veröffentlichungstag und Bekanntmachung des Hinweises auf die Patenterteilung: **16.04.2008**
(21) Anmeldenummer: 05707625.9
(22) Anmeldetag: 25.02.2005
(51) Int. Cl.: H01L 51/30, H01L 51/40

(54) **VERFAHREN ZUR VERNETZUNG ORGANISCHER HALBLEITER**
METHOD FOR CROSS-LINKING AN ORGANIC SEMI-CONDUCTOR
PROCEDE DE RETICULATION DE SEMI-CONDUCTEURS ORGANIQUES

(30) Priorität: 26.02.2004 DE 102004009355
(43) Veröffentlichungstag der Anmeldung: 08.11.2006
(73) Patentinhaber: Merck Patent GmbH, 64293 Darmstadt (DE)
(72) Erfinder: BECKER, Heinrich, 65719 Hofheim (DE); MEERHOLZ, Klaus, 51503 Rösrath (DE); MÜLLER, David, Christoph, 80805 München (DE)
(86) Internationale Anmeldenummer: PCT/EP2005/001978
(87) Internationale Veröffentlichungsnummer: WO 2005/083812

(56) Entgegenhaltungen:
- WO-A-02/10129
- WO-A-02/21611
- US-A- 5 877 229
- J. V. CRIVELLO AND J. H. W. LAM: "Complex Triarylsulfonium Salt Photoinitiators. II. The Preparation of Several New Complex Triarylsulfonium Salts and the Influence of Their Structure in Photoinitiated Cationic Polymerization" JOURNAL OF POLYMER SCIENCE: POLYMER CHEMISTRY EDITION, Bd. 18, 1980, Seiten 2697-2714, XP002327674
- J. V. CRIVELLO AND J. H. W. LAM: "Diaryliodonium Salts. A New Class of Photoinitiators for Cationic Polymerization" MACROMOLECULES, Bd. 10, Nr. 6, 1977, Seiten 1307-1315, XP002327675
- HEINRICH BECKER ET AL: "45.1: Full-Color Polymer-LEDs by Solution Processing" 2003 SID INTERNATIONAL SYMPOSIUM DIGEST OF TECHNICAL PAPERS, Bd. 34/2, 20. Mai 2003 (2003-05-20), Seite 1286, XP007008351 SOCIETY FOR INFORMATION DISPLAY
- REICHMANIS E ET AL: "CHEMICAL AMPLIFICATION MECHANISMS FOR MICROLITHOGRAPHY" CHEMISTRY OF MATERIALS, AMERICAN CHEMICAL SOCIETY, WASHINGTON, US, Bd. 3, 1991, Seiten 394-407, XP001022549 ISSN: 0897-4756
- CLARKE T C ET AL: "PHOTOINITIATED DOPING" IBM TECHNICAL DISCLOSURE BULLETIN, IBM CORP. NEW YORK, US, Bd. 23, Nr. 8, Januar 1981 (1981-01), Seite 3852, XP000858064 ISSN: 0018-8689

## Beschreibung

Organische elektronische Vorrichtungen werden immer häufiger in kommerziellen Produkten verwendet oder stehen kurz vor der Markteinführung. Als Beispiele für bereits kommerzielle Produkte seien organische oder polymere Leuchtdioden (OLEDs, PLEDs) in Anzeige- und Display-Vorrichtungen genannt. Organische Solarzellen (O-SCs), organische Feld-Effekt-Transistoren (O-FETs), organische Dünnfilmtransistoren (O-TFTs), organische Schaltelemente (O-ICs), organische optische Verstärker oder organische Laserdioden (O-Laser) sind in einem Forschungsstadium weit fortgeschritten und könnten in der Zukunft große Bedeutung erlangen.

Ein Vorteil, den elektronische Vorrichtungen, welche auf polymeren oder oligomeren organischen Halbleitern basieren, besitzen, ist, dass diese aus Lösung hergestellt werden können, was mit geringerem technischen und Kostenaufwand verbunden ist als Vakuumprozesse, wie sie im Allgemeinen für niedermolekulare Verbindungen durchgeführt werden. So können beispielsweise einfarbige elektrolumineszierende Vorrichtungen vergleichsweise einfach erzeugt werden, indem die Materialien durch Flächenbeschichtung aus Lösung verarbeitet werden. Üblicherweise wird hier die Strukturierung, d. h. die Ansteuerung der einzelnen Bildpunkte, bei den "Zuleitungen", d. h. beispielsweise bei den Elektroden, durchgeführt. Dies kann z. B. durch Schattenmasken nach Art einer Schablone erfolgen. Für die industrielle Massenfertigung ergeben sich hieraus jedoch deutliche Nachteile: Die Masken sind nach ein- oder mehrmaliger Benutzung durch Belagbildung unbrauchbar und müssen aufwändig regeneriert werden. Für die Produktion wäre es daher wünschenswert, einen Prozess zur Verfügung zu haben, für den keine Schattenmasken für die Deposition der Materialien benötigt werden. Flächenbeschichtungen und Strukturierung durch Schattenmasken können außerdem nicht angewandt werden, wenn beispielsweise Vollfarbdisplays aus Lösung erzeugt werden sollen. Hierfür müssen die drei Grundfarben (rot, grün, blau) in einzelnen Pixels mit hoher Auflösung nebeneinander aufgebracht werden. Während bei niedermolekularen aufdampfbaren Molekülen die Bildpunkte durch das Aufdampfen der einzelnen Farben durch Schattenmasken erzeugt werden können (mit den oben bereits erwähnten damit verbundenen Schwierigkeiten), ist dies für polymere Materialien nicht möglich. Hier besteht ein Ausweg darin, die aktive Schicht direkt strukturiert aufzubringen. Dass dies erhebliche Probleme bereitet, ist schon aus den Dimensionen verständlich: Es müssen Strukturen im Bereich von einigen 10 µm bei Schichtdicken im Bereich von weniger als 100 nm bis zu wenigen µm geschaffen werden. In letzter Zeit wurden hierfür insbesondere verschiedene Drucktechniken, wie beispielsweise Tintenstrahldruck, in Erwägung gezogen. Jedoch ist keine dieser Drucktechniken bislang soweit ausgereift, dass sie für einen Massenfertigungsprozess anwendbar wäre. Deshalb muss die Strukturierbarkeit durch Drucktechniken derzeit noch als ungelöstes Problem angesehen werden.

Ein anderer Ansatz wurde in WO 02/10129 und Nature 2003, 421, 829 vorgeschlagen. Dort werden strukturierbare organische Halbleiter und Leiter beschrieben, die mindestens eine zur Vernetzung befähigte Oxetangruppe enthalten, deren Vernetzungsreaktion gezielt ausgelöst und gesteuert werden kann. Dafür wird den Materialien mindestens ein Photoinitiator zugemischt. Durch Bestrahlung mit UV-Licht in die Absorptionsbande des Initiators wird eine Säure erzeugt, die durch kationische, ringöffnende Polymerisation eine Vernetzungsreaktion auslöst. Durch strukturierte Bestrahlung kann so ein Muster von Bereichen mit vernetztem und unvernetztem Material erhalten werden. Durch Spülen mit geeigneten Lösemitteln können dann die Bereiche mit unvernetztem Material entfernt werden, was zur gewünschten Strukturierung führt. Die vernetzten Bereiche bleiben wegen Unlöslichkeit zurück. So kann das nachfolgende Aufbringen mehrerer Schichten (bzw. anderer Materialien in Nachbarschaft zum ersten Material) nach erfolgter Vernetzung durchgeführt werden. Die Bestrahlung, wie sie zur Strukturierung angewandt wird, ist ein Standardprozess der heutigen Elektronik (Photolithographie) und kann z. B. mit Lasern oder durch flächige Bestrahlung durch eine entsprechende Photomaske erfolgen. Diese Maske birgt hier keine Gefahr der Belegung, da ja nur Strahlung und kein Materialfluss durch die Maske zu verzeichnen ist.

Allerdings verbleiben nach der Vernetzung die Photosäure, bzw. deren Reaktionsprodukte als Verunreinigung in der elektronischen Vorrichtung. Es ist allgemein anerkannt, dass sowohl organische wie auch anorganische Verunreinigungen den Betrieb elektronischer Vorrichtungen stören können. Deshalb wäre es wünschenswert, die Verwendung der Photosäure weitestmöglich reduzieren zu können. Weiterhin kann die hochenergetische UV-Strahlung, die bislang zum Vernetzen notwendig ist, zu Nebenreaktionen und Zersetzungen des organischen Halbleiters führen und somit wiederum den Betrieb der elektronischen Vorrichtung stören. Es wäre also wünschenswert, hier eine mildere Vernetzungsmethode zur Verfügung zu haben.

In der nicht offen gelegten Anmeldung DE 10340711.1 wird beschrieben, wie eine kationisch vernetzbare Zwischenschicht zwischen der emittierenden Schicht und einer dotierten Ladungsinjektionsschicht in einer OLED durch thermische Behandlung vernetzt werden kann, vermutlich durch Protonen aus der dotierten Ladungsinjektionsschicht. Dadurch kann der Zusatz einer Photosäure vermieden werden. Diese Methode ist jedoch nur anwendbar, wenn einerseits eine dotierte Ladungsinjektionsschicht vorhanden ist und andererseits großflächig vernetzt werden soll. Eine Strukturierung ist auf diese Weise nicht möglich, so dass diese Methode keine breite Anwendung finden kann.

In US 6593388 wird beschrieben, wie die Geschwindigkeit einer kationischen Photopolymerisation beschleunigt werden kann, indem einer Mischung eines kationisch photopolymerisierbaren Monomers und eines Onium-Salzes ein polymerer Photosensibilisator, der im Bereich von 300 bis 600 nm absorbiert, zugemischt wird und die Mischung bestrahlt wird. Auch niedermolekulare Photosensibilisatoren sind hierfür mehrfach in der Literatur beschrieben (z. B. J. V. Crivello, Designed Monomers and Polymers 2002, 5, 141). Dadurch läuft die Polymerisation schneller ab, und es kann mit Strahlung geringerer Energie eingestrahlt werden. Der Nachteil, den ein zugemischter Photosensibilisator, unabhängig davon, ob er niedermolekular oder polymer ist, für organische elektronische Vorrichtungen darstellt, ist jedoch offensichtlich: Es handelt sich hier um elektronisch aktive Verbindungen, die nach Vernetzung nicht oder zumindest nicht vollständig aus dem Film abgetrennt werden können und die als Verunreinigung die Funktion der Vorrichtung stören können, beispielsweise durch Beeinflussung des Ladungstransports oder durch Reabsorption und gegebenenfalls Reemission von Licht. Dieser Ansatz ist also nicht für die Vernetzung organischer Halbleiter geeignet.

WO 02/10129 offenbart ein Verfahren zur Vernetzung Oxetan-funktionalisierter, organischer Halbleiter, initiiert durch einen Onium-Photoinitiator.

Überraschend wurde gefunden, dass die Vernetzung effizienter und schneller als gemäß dem Stand der Technik abläuft, wenn zur Initiierung der Vernetzung Oxetan-funktionalisierter organischer Halbleiter nicht in die Absorptionsbande der Photosäure eingestrahlt wird. Dadurch wird weniger Initiator (Photosäure) benötigt, wodurch die Vorrichtung nach der Vernetzung weniger Verunreinigungen (insbesondere Reaktionsprodukte der Photosäure) enthält und dadurch bessere Eigenschaften aufweist. Weiterhin muss nicht, wie bei Vernetzung gemäß dem Stand der Technik, mit kurzwelliger UV-Strahlung bestrahlt werden, um die Vernetzungsreaktion zu initiieren. Dies bringt deutliche Vorteile, da viele organische Verbindungen nicht photostabil sind, insbesondere gegenüber kurzwelligem UV-Licht. Durch die milderen Vernetzungsbedingungen lassen sich ungewollte Nebenreaktionen vermeiden. Dadurch weist die elektronische Vorrichtung bessere Eigenschaften, inbesondere in Bezug auf die Effizienz und die Lebensdauer, auf als Vorrichtungen, deren Vernetzung gemäß Stand der Technik durch kürzerwellige (und somit energiereichere) UV-Bestrahlung initiiert wurden.

Gegenstand der Erfindung ist ein Verfahren zur Vernetzung Oxetan-funktionalisierter, organischer Halbleiter und Leiter, bevorzugt oligomerer und polymerer organischer Halbleiter und Leiter, initiiert durch mindestens eine zugesetzte Onium-Verbindung und durch Bestrahlung, dadurch gekennzeichnet, dass bei einer Wellenlänge eingestrahlt wird, bei der die Extinktion der Onium-Verbindung höchstens 5% der maximalen Extinktion beträgt.

Die Extinktion der Onium-Verbindung beträgt bei der Einstrahlungswellenlänge höchstens 5% der maximalen Extinktion bevorzugt noch höchstens 3%, besonders bevorzugt noch höchstens 1 % der maximalen Extinktion.
Es hat sich gezeigt, dass besonders gute Ergebnisse erzielt werden, wenn mindestens 80 nm langwelliger als das Absorptionsmaximum der Onium-Verbindung eingestrahlt wird, bevorzugt mindestens 100 nm langwelliger. Jedoch kann man auch schon gute Ergebnisse erzielen, wenn der Abstand zwischen Einstrahlungswellenlänge und Absorptionsmaximum der Onium-Verbindung weniger als 80 nm beträgt.

Oxetan-funktionalisiert im Sinne dieser Anmeldung bedeutet, dass mindestens eine Oxetangruppe kovalent an mindestens einen organischen Halbleiter bzw. Leiter gebunden ist, gegebenenfalls über einen Spacer.

Unter einer Onium-Verbindung wird eine salzartige Verbindung mit einem koordinativ gesättigten Kation verstanden, das durch die Anlagerung von Protonen oder anderen positiven Gruppen an das Zentralatom eines neutralen Moleküls gebildet wird. Hierzu gehören beispielweise Ammonium-Verbindungen (R₄N⁺), Oxonium-Verbindungen (R₃O⁺), Sulfonium-Verbindungen (R₃S⁺), Chloronium-Verbindungen (R₂Cl⁺), Bromonium-Verbindungen (R₂Br⁺), lodonium-Verbindungen (R₂I⁺), etc.. Für einige dieser Verbindungen ist bekannt, dass sie als Photosäure wirken, d. h. unter Bestrahlung, im Allgemeinen in einem Wellenlängenbereich zwischen 200 und 300 nm, durch Zersetzungsreaktionen Protonen freisetzen. Bekannt und besonders geeignet sind dafür Diaryliodonium-, Diarylbromonium-, Diarylchloronium-, Triarylsulfonium- und Dialkylphenacylsulfonium-Salze. Konkrete Beispiele für Photosäuren sind 4-(Thio-phenoxyphenyl)-diphenylsulfonium hexafluoroantimonat oder {4-[(2-Hydroxytetradecyl)-oxyl]-phenyl}-phenyliodonium hexafluoroantimonat und andere, wie in EP 1308781 beschrieben.

Organische Halbleiter im Sinne dieses Textes sind Verbindungen, die als Feststoff bzw. als Schicht halbleitende Eigenschaften aufweisen, d. h. bei denen die Energielücke zwischen Leitungs- und Valenzband zwischen 0.1 und 4 eV liegt. Als organische Halbleiter bzw. Leiter kommen prinzipiell niedermolekulare, oligomere, dendritische oder polymere halbleitende bzw. leitende Materialien in Frage. Unter einem organischen Material im Sinne dieser Erfindung sollen nicht nur rein organische Materialien, sondern auch metallorganische Materialien und Metallkoordinationsverbindungen mit organischen Liganden verstanden werden. Dabei können die Materialien konjugiert, nicht-konjugiert oder auch teilkonjugiert sein, bevorzugt jedoch konjugiert oder teilkonjugiert, besonders bevorzugt konjugiert.

Ein weiterer Gegenstand der Erfindung sind organische halbleitende Schichten, dadurch gekennzeichnet, dass diese durch das erfindungsgemäße Verfahren vernetzt wurden.

Nochmals ein weiterer Gegenstand der Erfindung ist eine Methode zur Herstellung organischer elektronischer Vorrichtungen, dadurch gekennzeichnet, dass für mindestens eine Schicht das erfindungsgemäße Verfahren zur Vernetzung eines organischen Halbleiters oder Leiters verwendet wird.

Nochmals ein weiterer Gegenstand der Erfindung sind organische elektronische Vorrichtungen, dadurch gekennzeichnet, dass diese mindestens eine Schicht enthalten, die nach dem erfindungsgemäßen Verfahren vernetzt wurde.

Schichten der an sich bekannten, vernetzten organischen Halbleiter und Leiter und elektronische Bauteile, die solche Schichten enthalten, sind in der Literatur bereits beschrieben. Die nach dem erfindungsgemäßen Verfahren hergestellten Schichten und elektronischen Bauteile zeigen gegenüber den bislang beschriebenen verbesserte morphologische und elektronische Eigenschaften (dies ist u. a. in Beispiel 7 deutlich belegt). Insbesondere werden die Resistenz der Schicht gegenüber Lösemitteln und die Effizienz und Lebensdauer der elektronischen Vorrichtung durch die verbesserten Vernetzungsbedingungen erheblich verbessert.

Bevorzugt sind organische Halbleiter und Leiter, bei denen mindestens ein H-Atom durch eine Gruppe der Formel (1), Formel (2), Formel (3) oder Formel (4) ersetzt ist, 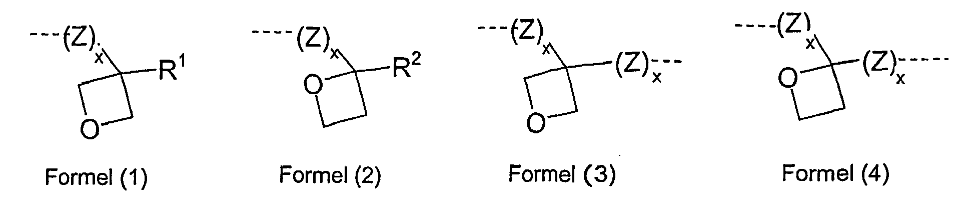 wobei für die verwendeten Symbole und Indizes gilt:
- R¹: ist bei jedem Auftreten gleich oder verschieden H, eine geradkettige, verzweigte oder cyclische Alkyl-, Alkoxyalkyl-, Alkoxy- oder Thioalkoxy-Gruppe mit 1 bis 20 C-Atomen, eine Aryl- oder Heteroaryl-Gruppe mit 4 bis 20 aromatischen Ringatomen oder eine Alkenylgruppe mit 2 bis 10 C-Atomen, bei denen ein oder mehrere Wasserstoffatome durch Halogen oder CN ersetzt sein können und ein oder mehrere nicht benachbarte C-Atome durch -O-, -S-, -CO-, -COO- oder -O-CO- ersetzt sein können;
- R²: ist bei jedem Auftreten gleich oder verschieden H, eine geradkettige, verzweigte oder cyclische Alkyl- oder Alkoxyalkylgruppe mit 1 bis 20 C-Atomen, eine Aryl- oder Heteroaryl-Gruppe mit 4 bis 20 aromatischen Ringatomen oder eine Alkenylgruppe mit 2 bis 10 C-Atomen, bei denen ein oder mehrere Wasserstoffatome durch Halogen oder CN ersetzt sein können und ein oder mehrere nicht benachbarte C-Atome durch -O-, -S-, -CO-, -COO- oder -O-CO- ersetzt sein können;
- Z: ist bei jedem Auftreten gleich oder verschieden eine bivalente Gruppe -(CR³R⁴)ₙ-, bei der auch ein oder mehrere nicht benachbarte C-Atome durch -O-, -S-, -CO-, -COO- oder -O-CO- ersetzt sein können, oder eine bivalente Aryl- oder N-, S- und/oder O-Heteroarylgruppe mit 4 bis 40 C-Atomen, die auch mit ein oder mehreren Resten R³ substituiert sein kann;
- R³, R⁴: ist bei jedem Auftreten gleich oder verschieden H, eine geradkettige, verzweigte oder cyclische Alkyl-, Alkoxy-, Alkoxyalkyl- oder Thioalkoxy-Gruppe mit 1 bis 20 C-Atomen, eine Aryl- oder Heteroaryl-Gruppe mit 4 bis 20 aromatischen Ringatomen oder eine Alkenyl-Gruppe mit 2 bis 10 C-Atomen, bei denen ein oder mehrere Wasserstoffatome auch durch Halogen oder CN ersetzt sein können; dabei können auch Reste R³ bzw. R⁴ miteinander bzw. mit R¹ oder R² ein Ringsystem bilden;
- n: ist bei jedem Auftreten gleich oder verschieden eine ganze Zahl zwischen 0 und 30, vorzugsweise zwischen 1 und 20, insbesondere zwischen 2 und 12,
- x: ist bei jedem Auftreten gleich oder verschieden 0, 1, 2, 3, 4 oder 5, bevorzugt 1, 2 oder 3,
mit der Maßgabe, dass die Anzahl der Gruppen gemäß Formel (1) bzw. Formel (2) bzw. Formel (3) bzw. Formel (4) durch die maximal verfügbaren, d. h. substituierbaren H-Atome des organischen Halbleiters oder Leiters begrenzt ist.

Durch die gestrichelte Bindung in den Formeln (1) bis (4) wird die Anknüpfung an den organischen Halbleiter angedeutet. Sie ist hier nicht als Methylgruppe zu verstehen.

Organische Halbleiter und Leiter enthaltend Gruppen gemäß Formel (3) und Formel (4) sind neu. Sie sind deshalb ebenfalls Gegenstand der vorliegenden Erfindung.

Besonders bevorzugt sind organische Halbleiter und Leiter, bei denen mindestens ein H-Atom durch eine Gruppe der Formel (1) ersetzt ist.

In einem Aspekt der Erfindung handelt es sich um einen organischen Leiter. Dieser wird bevorzugt als Ladungsinjektions- und/oder Ladungstransportmaterial eingesetzt. Dabei kann der organische Leiter entweder elektronenleitende oder lochleitende Eigenschaften aufweisen.

In einem weiteren Aspekt der Erfindung handelt es sich um einen organischen Halbleiter. Dieser wird bevorzugt als Ladungsinjektionsmaterial (für Löcher oder für Elektronen) und/oder als Ladungstransportmaterial (für Löcher oder für Elektronen) und/oder als Emissionsmaterial, das entweder aus dem Singulett- oder aus dem Triplettzustand emittieren kann, und/oder als Blockiermaterial, das beispielsweise ein Loch-, ein Elektronen- und/oder ein Excitonenblockiermaterial sein kann, eingesetzt.

In einem bevorzugten Aspekt der Erfindung handelt es sich bei der vernetzbaren Verbindung um eine lichtemittierende Verbindung. Diese kann durch die erfindungsgemäße Vernetzungsmethode besonders effizient vernetzt werden, wodurch ein einfacher Weg zu strukturierten elektronischen Vorrichtungen mit verbesserten physikalischen Eigenschaften gegeben ist.

Die vernetzbare Schicht kann auch eine Oxetan-haltige "Pufferschicht" sein, die zwischen einem leitfähigen, dotierten Polymer und einem organischen Halbleiter eingebracht wird. Die Verwendung einer solchen Pufferschicht ist in der nicht offen gelegten Anmeldung DE 10340711.1 beschrieben. Auch hier bietet die erfindungsgemäße Vernetzungsmethode eine einfache Möglichkeit zur effizienten Vernetzung der Schicht.

Bevorzugte Onium-Verbindungen sind Diaryliodonium-, Diarylbromonium-, Diarylchloronium- und Triarylsulfonium-Salze, besonders bevorzugt Diaryliodonium-, Diarylbromonium- und Diarylchloronium-Salze, wobei die Anionen variabel sind, jedoch im Allgemeinen schwach nucleophile Anionen, wie z. B. PF₆⁻, SbF₆⁻, SbCl₆⁻, BF₄⁻, B(C₆F₅)₄⁻, etc., gewählt werden.

Der Anteil der Onium-Verbindung in der Mischung bzw. in der Schicht kann in weiten Bereichen variiert werden. Es ist jedoch bevorzugt, den Anteil möglichst gering zu halten, damit die Reaktionsprodukte der Zersetzungsreaktion die Funktion der elektronischen Vorrichtung möglichst wenig beeinflussen. Andererseits muss gewährleistet sein, dass der Anteil ausreicht, um die Vernetzung möglichst vollständig zu initiieren. Der Anteil des Initiators (der Onium-Verbindung) sollte dabei für jeden organischen Halbleiter und für jede Onium-Verbindung separat optimiert werden, da unterschiedliche elektronische Eigenschaften des Halbleiters auch dessen Eigenschaften bei der Vernetzung beeinflussen. Allgemein hat es sich als bevorzugt erwiesen, wenn der Anteil der Onium-Verbindung in der Mischung zwischen 0.01 und 5 Gew.% gewählt wird, besonders bevorzugt zwischen 0.05 und 3 Gew.%, insbesondere zwischen 0.1 und 2 Gew.%. Diese Werte gelten vor allem für Diaryliodonium-Verbindungen und können für andere Verbindungen durchaus hiervon abweichen. Dabei hat es sich als Richtschnur ergeben, dass bei Halbleitern, die nicht leicht oxidierbar sind, ein sehr geringer Anteil der Onium-Verbindung für eine gute Vernetzung ausreichend ist, bevorzugt im Bereich von 0.1 bis 0.5 Gew.%, während bei sehr elektronenreichen, leicht oxidierbaren Halbleitern ein höherer Anteil der Onium-Verbindung, bevorzugt im Bereich von 1 bis 2 Gew.%, für eine gute Vernetzung benötigt wird.

Es kann auch bevorzugt sein, die Schicht nach der Bestrahlung nachzubehandeln, um die Vernetzung zu vervollständigen und/oder um reaktive Zwischenprodukte aus der Schicht zu entfernen.

Dafür kann die Schicht nach erfolgter Bestrahlung getempert werden, bevorzugt in einem Temperaturbereich von 50 bis 250 °C, insbesondere von 80 bis 150 °C. Die Dauer des Temperns beträgt bevorzugt 0.1 bis 10 Minuten, insbesondere 1 bis 3 Minuten. Ohne an eine bestimmte Theorie gebunden sein zu wollen, vermuten wir, dass dies die Mobilität der reaktiven Oxetaneinheiten im Film steigert und somit den Vernetzungsgrad erhöht. Die Temperatur wird dabei den eingesetzten Materialien angepasst. Dadurch sind Polymernetzwerke erhältlich, die de facto unlöslich in THF und anderen gängigen organischen Lösemitteln sind.

Weiterhin bevorzugt wird die Schicht nach erfolgter Bestrahlung und gegebenenfalls nach dem Tempern mit einem Lösemittel, beispielsweise THF, gespült. Gegebenenfalls können diesem Lösemittel weitere Zusatzstoffe beigemischt oder darin gelöst sein, so z. B. Reduktionsmittel (z. B. LiAIH₄, MBDQ-Radikalanionen = 2,6-Dimethyl-2',6'-di-*tert*butyl-dichinon-Radikalanionen, Hydrazin, Hydrazin-Derivate, o. ä.) oder schwache Basen/Nucleophile (z. B. Tetrabutylammoniumacetat oder -bromid, etc.). Die Konzentration dieser Zusatzstoffe ist niedrig, bevorzugt unter 10⁻⁴ mol/l, besonders bevorzugt unter 10⁻⁵ mol/l. Überraschend wurde gefunden, dass dadurch die Schicht bessere elektronische Eigenschaften aufweist. Ohne an eine bestimmte Theorie gebunden sein zu wollen, vermuten wir, dass die Reduktionsmittel eventuell entstandene Radikalkationen (Reduktion zum Neutralmolekül) entfernen und die Nucleophile/Basen kationische Zwischenprodukte (z. B. Oxoniumionen) der Vernetzungsreaktion neutralisieren.

Die Vernetzungsreaktion, die in Anwesenheit einer Onium-Verbindung und durch Bestrahlung initiiert verläuft, ist gegenüber dem Stand der Technik dadurch gekennzeichnet, dass nicht in die Absorptionsbande der Onium-Verbindung eingestrahlt wird. Hier ist es bevorzugt, mindestens 80 nm langwelliger als das Absorptionsmaximum einzustrahlen, besonders bevorzugt mindestens 100 nm langwelliger als das Absorptionsmaximum der Onium-Verbindung. Diese Zahlenwerte entsprechen dem Abstand der maßgeblichen Maxima von Absorption und Emission. Dadurch kann die Onium-Verbindung nicht direkt als Photosäure wirken, also nicht direkt ein Proton freisetzen. Überraschend wurde gefunden, dass die Vernetzung der Oxetangruppen dennoch sehr effektiv und schnell stattfindet und die vernetzte Schicht sogar resistenter ist, wenn unter ansonsten gleichen Bedingungen statt in die Absorptionsbande der Onium-Verbindung in die Absorptionsbande des organischen Halbleiters oder Leiters eingestrahlt wird. Ohne an eine bestimmte Theorie gebunden sein zu wollen, vermuten wir, dass der oxetanfunktionalisierte Leiter bzw. Halbleiter als Photosensibilisator für die Reaktion dient. Prinzipiell ist die photosensibilisierte kationische Polymerisation von Oxetanen in der Literatur bekannt, wobei als Sensiblisatoren auch separat zugesetzte Polymere zum Einsatz kommen. Bisher wurde jedoch nicht beschrieben, dass ein "Makro-Monomer", also ein Polymer, das vernetzbare Gruppen trägt, auch selber als Photosensibilisator dienen kann. Der Sensibilisator ist dadurch in Anteilen von fast 100 % im Film vorhanden. Dass diese Art der "Auto-Sensibilisierung" tatsächlich funktioniert, ist ein neues und überraschendes Ergebnis. Gegenüber der Photosensibilisierung durch separat zugesetzte Sensibilisatoren ist dies von enormem Vorteil für die Herstellung elektronischer Bauteile, da dadurch Verunreinigungen, wie sie auch zugesetzte Sensibilisatoren darstellen, weitestgehend vermieden werden können. Dadurch werden sehr gute elektronische Eigenschaften erhalten.

Bevorzugt erfolgt die Einstrahlung in die Absorptionsbande des organischen Halbleiters, insbesondere mit einer Wellenlänge im Bereich von bis zu +/- 50 nm vom Absorptionsmaximum der jeweiligen Absorptionsbande des organischen Halbleiters. Für konjugierte Polymere auf Basis von Poly-para-Phenylenderivaten im weitesten Sinne (Polyfluorene, Poly-spirobifluorene, etc.) erfolgt die Einstrahlung beispielsweise bevorzugt im Bereich von 370 bis 450 nm. Die Dauer der Bestrahlung kann sehr kurz gewählt werden, wobei immer noch sehr gute Vernetzungsergebnisse erzielt werden. Bevorzugt wird mit einer Dauer von 0.01 bis 10 Sekunden bestrahlt, besonders bevorzugt von 0.1 bis 3 Sekunden, wobei diese Zeiten einer Lichtintensität von < 1 mW/cm² entsprechen; bei höheren Intensitäten können gegebenenfalls noch kürzere Belichtungszeiten ausreichend sein.

In einem weiteren bevorzugten Aspekt der Erfindung handelt es sich bei den vernetzbaren Verbindungen um Ladungstransportverbindungen. Hier bietet das neue Verfahren noch einen zusätzlichen unerwarteten Vorteil: Wird der Film der erfindungsgemäß vernetzten Ladungstransportverbindung nicht, wie allgemein üblich, nach der Vernetzung behandelt, um die Reaktion zu beenden und Ladungsträger zu entfernen, so weist dieser Film deutlich bessere Ladungstransporteigenschaften auf als ein Film, der wie üblich getempert und gewaschen wurde. Ohne an eine bestimmte Theorie gebunden sein zu wollen, glauben wir, dass durch die photoinduzierte Reaktion zwischen der Ladungstransportverbindung und der zugesetzten Photosäure auf der Ladungstransportverbindung reaktive Spezies, beispielsweise Radikalkationen, gebildet werden, die einer (oxidativen) Dotierung des Polymers gleichkommen, wodurch die Ladungstransporteigenschaften deutlich verbessert werden. Durch den Anteil des Initiators und die genauen Bedingungen der anschließenden Temper- und/oder Spülschritte mit oder ohne Additive lässt sich der Grad der Dotierung einstellen. Dies ist in den Bespielen 4 bis 6 belegt. Ist eine Dotierung jedoch unerwünscht, lässt diese sich auch durch einen Temperschritt und einen Spülschritt wieder entfernen.

In einer bevorzugten Ausführungsform wird das erfindungsgemäße Verfahren also für Ladungstransportmaterialien angewandt, um außer der Vernetzung gleichzeitig eine Dotierung der Schicht zu erzeugen.

Eine vergleichbare alternative Methode zur gleichzeitigen Vernetzung und Dotierung von Ladungstransportmaterialien ist die direkte oxidative Initiierung der Vernetzungsreaktion durch Zusatz von Oxidationsmitteln. Diese ist ebenfalls Gegenstand der vorliegenden Erfindung. Dadurch lassen sich auch höhere Dotierungsgrade erzeugen, als dies photosensibilisiert möglich ist. Als Oxidationsmittel kommen hierfür beispielsweise Nitrosonium-Salze in Frage, aber auch Salze von Triarylammonium-Radikalkationen oder weitere Oxidationsmittel, deren Reaktionsprodukte nach der Vernetzung leicht aus dem Film entfernt werden können, wie beispielsweise flüchtige bzw. gut lösliche Verbindungen, bzw. solche, deren Reaktionsprodukte inert sind und im Film bei Betrieb der elektronischen Vorrichtung nicht stören. Gut handhabbare NO-Verbindungen sind hier beispielsweise NO(BF₄) oder NO(SbF₆). Tris(4-bromphenylammonium)-Salze sind Beispiele für stabile Radikalkationen. Durch das zugesetzte Oxidationsmittel kann einerseits die Vernetzung der Oxetangruppen gestartet werden, andererseits ist so gleichzeitig die oxidative Dotierung eines Ladungstransportmaterials möglich. Wenn die Vernetzung durch Zusatz von Oxidationsmitteln und nicht photoinduziert erfolgt, ist allerdings die Möglichkeit der Strukturierung nicht mehr gegeben, weshalb insbesondere für Polymere, die strukturiert werden sollen, die oben aufgeführte erfindungsgemäße Methode dem Zusatz von Oxidationsmitteln vorzuziehen ist.

Weiterhin sei an dieser Stelle erwähnt, dass für die photosensibilisierte Dotierung eines Ladungstransportmaterials durch Onium-Verbindungen die Anwesenheit von Oxetangruppen nicht zwingend erforderlich ist, wobei ohne die Oxetanfunktionalisierung natürlich die Möglichkeit der Vernetzung ausgeschlossen ist. Ein weiterer Gegenstand der Erfindung ist also auch die photosensibilisierte Dotierung von Ladungstransportmaterialien durch Onium-Verbindungen, dadurch gekennzeichnet, dass außerhalb der Absorptionsbande der Photosäure eingestrahlt wird, bevorzugt mindestens 80 nm langwelliger, besonders bevorzugt mindestens 100 nm langwelliger als das Absorptionsmaximum der Onium-Verbindung.

Für die Herstellung der Vorrichtungen wird in der Regel ein allgemeines Verfahren angewandt, das in WO 02/10129 und in der nicht offen gelegten Anmeldung DE 10340711.1 beschrieben ist und entsprechend der neuen Vernetzungsmethode, wie oben beschrieben, anzupassen ist.

Die organische elektronische Vorrichtung kann aus nur einer Schicht bestehen, die dann die Oxetan-haltige vernetzte Verbindung enthält, oder sie kann aus mehreren Schichten bestehen. Dabei kann es bevorzugt sein, wenn mehr als eine dieser Schichten vernetzt ist. Es kann auch bevorzugt sein, wenn nur eine Schicht vernetzt ist und die anderen Schichten unvernetzt sind. Weitere Schichten können leitend, z. B. eine dotierte leitende Ladungsinjektionsschicht, wie z. B. Polythiophen- oder Polyanilin-Derivate, sein. Sie können auch halbleitend oder nicht-leitend sein, wie beispielsweise die Verwendung von Verbindungen mit hoher Dielektrizitätskonstante, z. B. LiF, NaF, BaF₂ etc., als Elektroneninjektionsmaterial.

Elektronische Vorrichtungen im Sinne dieser Erfindung sind organische und polymere Leuchtdioden (OLEDs, PLEDs, z. B. EP-A-0 676 461, WO 98/27136), organische Solarzellen (O-SCs, z. B. WO 98/48433, WO 94/05045), organische Feld-Effekt-Transistoren (O-FETs, z. B. US 5705826, US 5596208, WO 00/42668), organische Dünnfilmtransistoren (O-TFTs), organische Schaltelemente (O-ICs, z. B. WO 95/31833, WO 99/10939), organische optische Verstärker oder organische Laserdioden (O-Laser, z. B. WO 98/03566), insbesondere aber organische und polymere Leuchtdioden. Organisch im Sinne dieser Erfindung bedeutet, dass mindestens eine Schicht, enthaltend mindestens einen organischen Halbleiter oder Leiter, vorhanden ist.

Überraschend bietet die neue Vernetzungsmethode folgende Vorteile gegenüber der photoinduzierten Vernetzung gemäß dem Stand der Technik, bei der in die Absorptionsbande der Photosäure eingestrahlt wird:
1) Die Vernetzung kann unter milderen Bedingungen durchgeführt werden als dies gemäß dem Stand der Technik möglich ist. Während bei Photosäuren energiereichere UV-Strahlung nötig ist, um die Freisetzung von Protonen und damit die Vernetzung zu initiieren, kann beim erfindungsgemäßen Verfahren die Reaktion mit Licht deutlich niedrigerer Energie (= längere Wellenlänge) initiiert werden. Insbesondere für organische Halbleiter und Leiter, die photochemisch instabil sind (und das betrifft die meisten organischen Halbleiter und Leiter bei der bislang benötigten UV-Strahlung), bietet die neue Vernetzungsmethode klare Vorteile, da somit Nebenreaktionen und Zersetzungen in der Schicht durch die hochenergetische UV-Strahlung weitestgehend vermieden werden können.
2) Die Vernetzung läuft schneller und effektiver ab, als dies gemäß dem Stand der Technik der Fall ist. Dadurch kann die Vernetzung in kürzerer Zeit durchgeführt werden, als dies momentan der Fall ist, was durch die kürzere Belichtungsdauer wiederum das Material schont und Nebenreaktionen reduziert. Außerdem stellt die kürzere Vernetzungsdauer auch im technischen Produktionsprozess einen deutlichen Vorteil dar. Die Strukturierung der Vorrichtung ist dadurch sehr effizient und ebenfalls in kürzerer Zeit als bisher möglich.
3) Die Schichten, die nach der erfindungsgemäßen Methode mit einem geringeren Zusatz von Photosäure vernetzt wurden, weisen eine bessere Resistenz gegenüber Lösemitteln auf. Dadurch lassen sie sich einerseits besser strukturieren, andererseits verbessert sich auch das Aufbringen mehrerer Schichten übereinander.
4) Die physikalischen Eigenschaften elektronischer Vorrichtungen, die nach der neuen Methode vernetzt wurden, insbesondere die Effizienz, die Betriebsspannung und die Lebensdauer, sind besser als die elektronischer Vorrichtungen, bei denen die Schichten nach Verfahren gemäß dem Stand der Technik vernetzt wurden. Dies ist ein unerwarteter und überraschender Effekt. Ohne an eine bestimmte Theorie gebunden sein zu wollen, vermuten wir, dass der reduzierte Photosäurezusatz für diesen positiven Effekt verantwortlich sein könnte, weil dadurch weniger Verunreinigungen (Reaktionsprodukte der Photosäure) in der Schicht verbleiben, und/oder dass der Effekt durch die Verwendung milderer Vernetzungsbedingungen und/oder die kürzere Belichtungsdauer zustande kommt.
5) Nach der photosensibilisierten Vernetzung der Schicht können Ladungen (Radikalkationen) auf dem organischen Halbleiter verbleiben. Dies ist insbesondere dann von Vorteil, wenn es sich um Ladungstransport- und/oder Ladungsinjektionsmaterialien handelt, da dann die zusätzlichen Ladungen als Dotierung wirken und somit die intrinsische Leitfähigkeit dieser Materialien erhöhen, was für Ladungstransporteigenschaften wünschenswert ist. Durch anschließende Temper- und/oder Spülschritte lässt sich der Grad der Dotierung gemäß der gewünschten Anwendung einstellen.

Die vorliegende Erfindung wird durch die folgenden Beispiele näher erläutert, ohne sie darauf einschränken zu wollen. In diesen Beispielen wird hauptsächlich auf organische und polymere Leuchtdioden eingegangen. Der Fachmann kann jedoch aus den aufgeführten Beispielen ohne erfinderisches Zutun weitere elektronische Vorrichtungen darstellen, wie beispielsweise O-SCs, O-FETs, O-ICs, optische Verstärker und O-Laser, um nur einige weitere Anwendungen zu nennen.

### Beispiele:

### Beispiel 1: Allgemeine Vorschrift zur auto-photosensibilisierten Vernetzung

Sämtliche Prozessschritte werden unter inertgas und unter Rotlicht (λ > 650 nm) durchgeführt. Unmittelbar vor dem Spincoaten werden die Lösungen des Halbleiters mit der entsprechenden Menge des Initators (im Allgemeinen 0.1 - 2 Gew.%) versetzt. Als Initiator wurde in den folgenden Beispielen {4-[(2-Hydroxytetradecyl)-oxyl]-phenyl}-phenyliodonium hexafluoroantimonat verwendet. Die Zugabe erfolgt aus frisch zubereiteter Stammlösung (10 mg/ml in THF). Direkt nach dem Spincoating-Prozess werden die vernetzbaren Filme großflächig oder durch eine Maske belichtet. Als Belichtungsquellen wurden neben Standard UV-Handlampen mit herkömmlichen 4W Röhren (UV-A, 365 nm) hauptsächlich GaN-Hochleistungs-UV-Dioden (395 nm) verwendet. Dioden dieses Typs sind in verschiedenen Bauformen im Elektronikfachhandel kommerziell zu beziehen. Belichtungszeiten von 1-3 s sind ausreichend, der Abstand zwischen Substrat und Belichtungsquelle beträgt einige Zentimeter. Um den Vernetzungsprozess zu vervollständigen, werden die Filme bei 90 - 150 °C ca. 1 min getempert. Nach dem Temperschritt bzw. vor dem Auftragen der nächsten Schicht werden die Filme mit THF gespült, beispielsweise auf dem Spincoater durch Aufträufeln einer entsprechenden Menge Lösemittel, gegebenenfalls unter Zusatz eines Reduktionsmittels. Optional kann nach dem Spülschritt ein weiterer Temperschritt ("post-bake") durchgeführt werden, beispielsweise 3 min. bei 180 - 200 °C.

### Beispiel 2: Allgemeine Vorschrift zur oxidativen Vernetzung

Sämtliche Prozessschritte werden unter Inertgas und unter Rotlicht (λ > 650 nm) durchgeführt. Unmittelbar vor dem Spincoaten werden die Halbleiter-Lösungen mit der entsprechenden Menge des Oxidationsmittels (beispielsweise 0.01 - 5 Gew.%) versetzt. Als Oxidationsmittel wurde hier eine Lösung von Nitrosonium hexafluoroantimonat (NO⁺SbF₆⁻) in Nitromethan verwendet. Die Zugabe erfolgt aus frisch zubereiteter Stammlösung (5 mg/ml in THF). Nach Zugabe des Oxidationsmittels werden die Filme durch Spincoating erhalten. Unmittelbar danach werden die Filme bei 100 °C getempert, was die Vernetzung der Filme bewirkt. Es sei angemerkt, dass durch die Konzentrierung der Lösung beim Spincoatingprozess schon eine bestimmter Grad an Vernetzung stattfindet, d. h. dass auch ohne Temperschritt eine gewisse Resistenz im Bereich von 40 - 80 % gegenüber Lösemitteln erzielt werden kann. Nach dem Temperschritt bzw. vor dem Auftragen der nächsten Schicht werden die Filme mit THF gespült, beispielsweise auf dem Spincoater durch Aufträufeln einer entsprechenden Menge Lösemittel. Bei hohen Dotierungskonzentrationen, d. h. bei Zugabe von mehr als 1 Gew.% NO⁺SbF₆⁻, wird üblicherweise eine zusätzliche Schicht aufgebracht, um eine direkte Wechselwirkung zwischen der hochdotierten Schicht und dem darauf folgenden, elektrolumineszierenden Polymer zu vermeiden. Dafür wird entweder derselbe Lochleiter oder ein Lochleiter mit höherem Oxidationspotenzial, das idealerweise zwischen dem der dotierten (oxidativ vernetzten) Schicht und dem EL-Polymer liegt, verwendet.

Die Verbindungen, die in den folgenden Beispielen 3 bis 6 verwendet wurden, sind im Folgenden abgebildet:

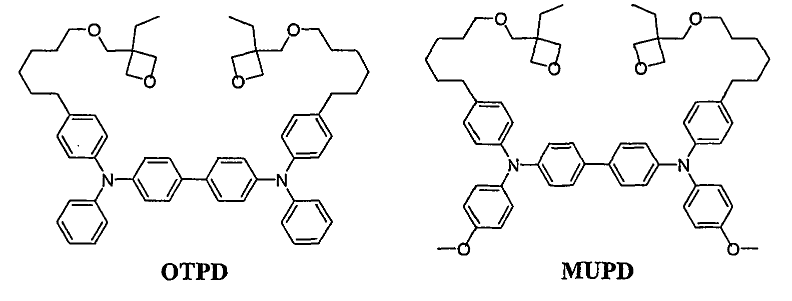

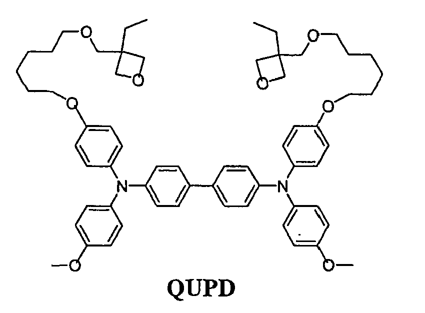

### Beispiel 3: Resistenz in Abhängigkeit der Temper-Temperatur

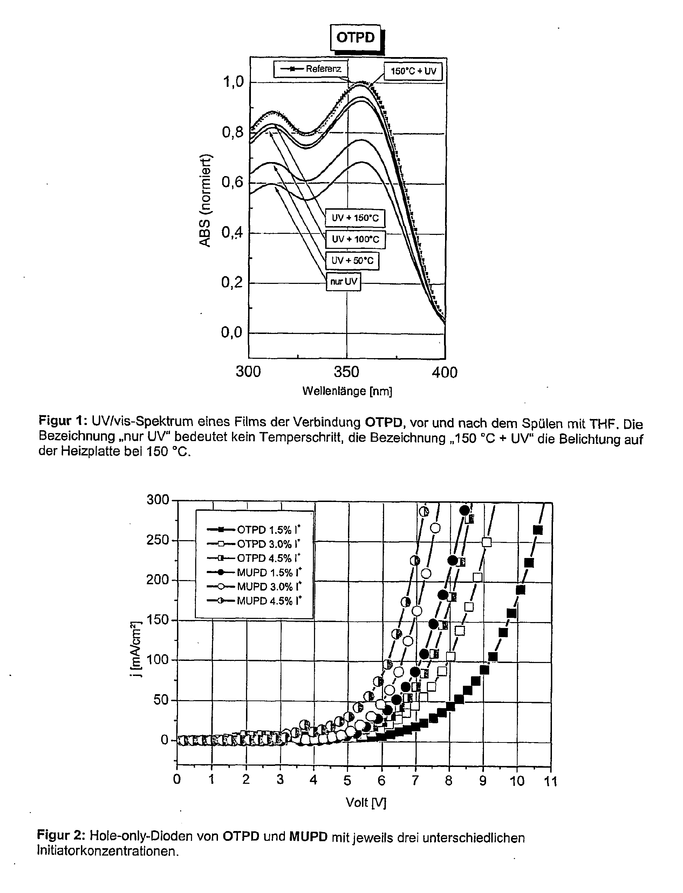

Eine Schicht der Verbindung **OTPD** wurde unter Verwendung von 0.5 Gew.% {4-[(2-Hydroxytetradecyl)-oxyl]-phenyl}-phenyliodonium hexafluoroantimonat vernetzt und bei unterschiedlichen Temperaturen getempert (50 °C, 100 °C, 150 °C). Alle Filme wurden 20 sec. mit einer UV-A-Handlampe belichtet. Variiert wurde die Temperatur der Heizplatte im Temperschritt. Von den entsprechenden Filmen wurden vor und nach dem Spülen mit THF UV/vis-Spektren aufgenommen. Über die Absorption lässt sich schließen, welcher Anteil des Films durch den Waschschritt entfernt wurde und wie gut die Resistenz der Filme gegenüber Lösemitteln ist. Die UV-vis-Spektren sind in Figur 1 dargestellt. Dort sind weiterhin die Spektren einer ungetemperten Schicht dargestellt, sowie einer Schicht, die bei 150 °C bestrahlt wurde.

### Beispiel 4: Abhängigkeit von der Initiatorkonzentration (Hole-only-Devices)

Von den Verbindungen **MUPD** und **OTPD** wurden Hole-only-Devices hergestellt. Dafür wurde als eine Elektrode ITO und als Gegenelektrode Calcium verwendet, da der Beitrag durch Elektronentransport in den entsprechenden Verbindungen als gering eingeschätzt und daher vernachlässigt wurde. Durch Radikalkationen dotierte Leiterschichten besitzen eine intrinsische Ladungsträgerdichte, die zur Erhöhung der Mobilität führt. Dieses Verhalten wurde in Abhängigkeit der Initiatorkonzentration (1.5 Gew.%, 3 Gew.%, 4.5 Gew.% {4-[(2-Hydroxytetradecyl)-oxyl]-phenyl}-phenyliodonium hexafluoroantimonat) untersucht. Die entsprech enden unvernetzten Filme konnten aufgrund ihrer geringen morphologischen Stabilität (T_{g} < 0 °C) nicht vermessen werden. Alle Filme wurden 20 sec. mit der UV-A-Handlampe belichtet und 1 min. bei 100 °C getempert. Die Filmdicken lagen bei 95 bis 105 nm und wurden auf 100 nm normiert. Die Hole-only-Kurven sind in Figur 2 dargestellt. Dabei fällt auf, dass steilere Kurven, als ein höherer Dotierungsgrad, erhalten werden, wenn eine höhere Initiatorkonzentration gewählt wird.

### Beispiel 5: Abhängigkeit vom Spülschritt (Hole-only-Devices)

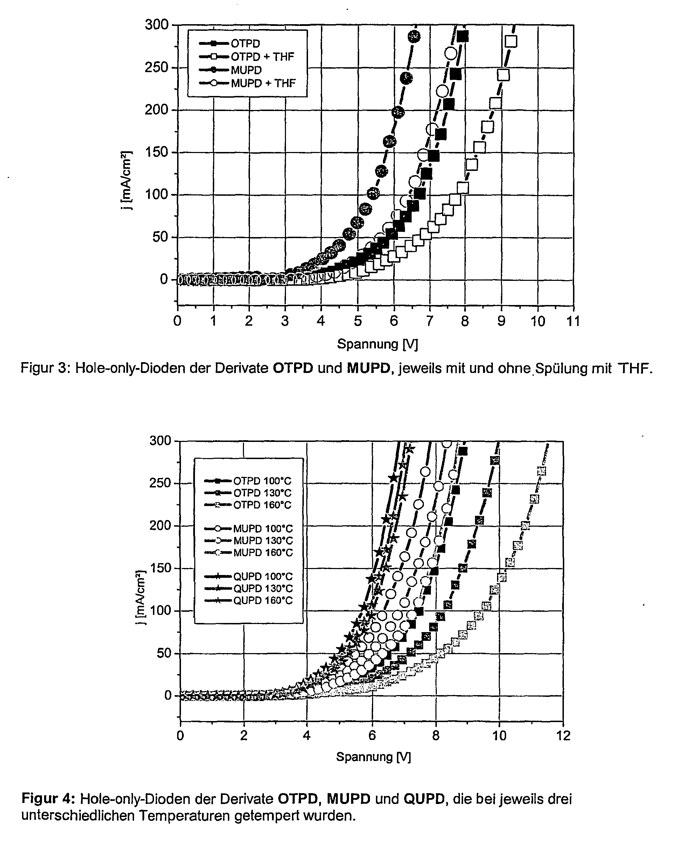

Von den Verbindungen OTPB und MUPD wurden wiederum Hole-only-Devices hergestellt. Alle Filme wurden unter Zusatz von 1.5% {4-[(2-Hydroxytetradecyl)-oxyl]-phenyl}-phenyliodonium hexafluoroantimonat 20 sec. mit einer UV-A-Handlampe belichtet und 1 min. bei 100°C getempert. Die Filmdicken lagen im Bereich von 100 bis 110 nm und wurden auf 100 nm normiert. Das unterschiedliche Verhalten der Filme mit und ohne Spülschritt mit THF wurde dann in den Hole-only-Devices beobachtet. Die entsprechenden Kurven sind in Figur 3 dargestellt. Dabei fällt auf, dass die Kurven der Devices, die ohne Spülschritt erhalten wurden, deutlich steiler verlaufen, also eine deutlich höhere Dotierung aufweisen. Umge kehrt lässt sich daraus schließen, dass durch einen geeigneten Spülschritt die Dotierung wieder rückgängig gemacht werden kann, wenn diese nicht gewünscht ist.

### Beispiel 6: Abhängigkeit von der Temper-Temperatur (Hole-only-Devices)

Von den Verbindungen **OTPB, MUPD** und **QUPD** wurden wieder Hole-only-Devices hergestellt. Dabei wurde die Abhängigkeit der Kurven von der Temperatur im Temperschritt untersucht. Um den Effekt der Temperatur auf die Dotierung möglichst deutlich zu sehen, wurden die Derivate mit 3 Gew.% {4-[(2-Hydroxytetradecyl)-oxyl]-phenyl}-phenyliodonium hexafluoroantimonat versetzt. Alle Filme wurden 20 sec. mit der UV-A-Handlampe belichtet und 1 min. bei verschiedenen Temperaturen (100°C, 130 °C, 160 °C) getempert. Die Filmdicken lagen bei 95 bis 105 nm und wurden auf 100 nm normiert. Die so erhaltenen Kennlinien sind in Figur 4 dargestellt. Die verschiedenen Temperaturen wirken sich auf die einzelnen Materialien unterschiedlich stark aus. Bei allen Materialien wird jedoch deutlich, dass eine niedrigere Temperatur im Temperschritt eine steilere Kennlinie verursacht.

### Beispiel 7: Deviceeigenschaften von PLEDs

Es wurden Zweischicht-Devices mit einem Aufbau ITO//20 nm PEDOT//80 nm Polymer//Ba//Ag erzeugt. Als Halbleiter wurden rot, grün und blau emittierende konjugierte Polymere auf Basis von Poly-Spirobifluoren verwendet, die mit Oxetangruppen funktionalisiert wurden. Diese Materialien und deren Synthese wurden bereits in der Literatur beschrieben *(*Nature 2003, 421, 829). Diesen wurden unterschiedliche Mengen Photoinitiator ({4-[(2-Hydroxytetradecyl)-oxyl]-phenyl}-phenyliodonium hexafluoroantimonat) zugesetzt, die Schichten wurden mit Licht unterschiedlicher Wellenlänge bestrahlt und bei unterschiedlichen Temperaturen getempert. In der folgenden Tabelle 1 sind die Vernetzungsbedingungen zusammengefasst, jeweils mit den Elektrolumineszenzergebnissen.

**Tabelle 1: Deviceeigenschaften von Polymeren, die auf unterschiedliche Methoden vernetzt wurden**

| Polymer^{a} | % Photosäure^{b} | λ/nm^{c} | t/s | Resistenz^{d} | Effizienz / cd/A | U / V @ 100 cd/m² |
|---|---|---|---|---|---|---|
| **P1** (Vergleich) | keine, nicht vernetzt | -- | -- | 0% | 2.9 | 4.5 |
| **P1** (Vergleich) | 0.5 | 302 | 3 | 100% | 3.0 | 4.5 |
| **P1** (Vergleich) | 0.4 | 302 | 1 | 90% | 3.1 | 4.5 |
| **P1** | 0.4 | 395 | 1 | 100% | 3.2 | 4.4 |
| **P2** (Vergleich) | keine, nicht vernetzt | -- | -- | 0% | 7.0 | 3.8 |
| **P2** (Vergleich) | 0.5 | 302 | 3 | 100% | 6.5 | 3.8 |
| **P2** (Vergleich) | 0.4 | 302 | 1 | 90% | 6.7 | 3.8 |
| **P2** | 0.4 | 395 | 1 | 100% | 6.9 | 3.7 |
| **P3** (Vergleich) | keine, nicht vernetzt | -- | -- | 0% | 1.0 | 8.3 |
| **P3** (Vergleich) | 0.5 | 302 | 3 | 100% | 1.1 | 7.5 |
| **P3** (Vergleich) | 0.4 | 302 | 1 | 90% | 1.2 | 7.5 |
| **P3** | 0.4 | 395 | 1 | 100% | 1.3 | 7.3 |

| | | | | | | |
|---|---|---|---|---|---|---|
| ^{a} Vernetzbare Polymere gemäß Nature 2003, 421, 829-833. ^{b} Gew.%, bezogen auf das Gewicht des Polymers ^{c} Wellenlänge der Bestrahlung ^{d} Resistenz gegenüber THF, bestimmt durch die Absorption in % nach dem Spülen mit THF (Referenz: ungespültes Substrat) | | | | | | |

Wie man deutlich sieht, erfolgt die Vernetzung mit der erfindungsgemäßen Methode in kürzerer Zeit und dennoch vollständiger, erkennbar an der Verwendung von weniger Initiator bei gleich bleibender Resistenz gegenüber Lösemitteln als dies gemäß dem Stand der Technik der Fall ist. Wird dagegen unter ansonsten gleichen Bedingungen in die Absorptionsbande der Photosäure nur kürzere Zeit eingestrahlt, so sinkt die Lösemittelresistenz des Polymerfilms.
Weiterhin sieht man an den Devicebeispielen, dass sich die Eigenschaften im Device, insbesondere Effizienz und Betriebsspannung, verbessern, wenn die Filme nach der erfindungsgemäßen Methode vernetzt wurden.

## Patentansprüche

1. Verfahren zur Vernetzung Oxetan-funktionalisierter, organischer Halbleiter und Leiter, initiiert durch mindestens eine zugesetzte Onium-Verbindung und durch Bestrahlung, **dadurch gekennzeichnet, dass** bei einer Wellenlänge eingestrahlt wird, bei der die Extinktion der Onium-Verbindung höchstens 5% der maximalen Extinktion beträgt.

2. Verfahren gemäß Anspruch 1, **dadurch gekennzeichnet, dass** mindestens 80 nm langwelliger als das Absorptionsmaximum der Onium-Verbindung bestrahlt wird.

3. Verfahren gemäß Anspruch 1 und/oder 2, **dadurch gekennzeichnet, dass** es sich um einen niedermolekularen, oligomeren, dendritischen oder polymeren organischen Halbleiter oder Leiter handelt.

4. Verfahren gemäß einem oder mehreren der Ansprüche 1 bis 3, **dadurch gekennzeichnet, dass** in dem organischen Halbleiter bzw. Leiter mindestens ein H-Atom durch eine Gruppe der Formel (1), Formel (2), Formel (3) oder Formel (4) ersetzt ist, 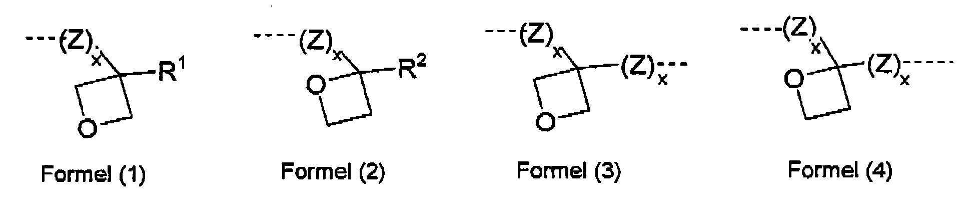 wobei für die verwendeten Symbole und Indizes gilt:
R¹ ist bei jedem Auftreten gleich oder verschieden H, eine geradkettige, verzweigte oder cyclische Alkyl-, Alkoxyalkyl-, Alkoxy- oder Thioalkoxy-Gruppe mit 1 bis 20 C-Atomen, eine Aryl- oder Heteroaryl-Gruppe mit 4 bis 20 aromatischen Ringatomen oder eine Alkenylgruppe mit 2 bis 10 C-Atomen, bei denen ein oder mehrere Wasserstoffatome durch Halogen oder CN ersetzt sein können und ein oder mehrere nicht benachbarte C-Atome durch -O-, -S-, -CO-, -COO- oder -O-CO- ersetzt sein können;
R² ist bei jedem Auftreten gleich oder verschieden H, eine geradkettige, verzweigte oder cyclische Alkyl- oder Alkoxyalkylgruppe mit 1 bis 20 C-Atomen, eine Aryl- oder Heteroaryl-Gruppe mit 4 bis 20 aromatischen Ringatomen oder eine Alkenylgruppe mit 2 bis 10 C-Atomen, bei denen ein oder mehrere Wasserstoffatome durch Halogen oder CN ersetzt sein können und ein oder mehrere nicht benachbarte C-Atome durch -O-, -S-, -CO-, -COO- oder -O-CO- ersetzt sein können;
Z ist bei jedem Auftreten gleich oder verschieden eine bivalente Gruppe -(CR³R⁴)ₙ-, bei der auch ein oder mehrere nicht benachbarte C-Atome durch -O-, -S-, -CO-, -COO- oder -O-CO- ersetzt sein können, oder eine bivalente Aryl- und/oder N-, S- und/oder O-Heteroarylgruppe mit 4 bis 40 C-Atomen, die auch mit ein oder mehreren Resten R³ substituiert sein kann;
R³, R⁴ ist bei jedem Auftreten gleich oder verschieden H, eine geradkettige, verzweigte oder cyclische Alkyl-, Alkoxy-, Alkoxyalkyl- oder Thioalkoxy-Gruppe mit 1 bis 20 C-Atomen, eine Aryl- oder Heteroaryl-Gruppe mit 4 bis 20 aromatischen Ringatomen oder eine Alkenyl-Gruppe mit 2 bis 10 C-Atomen, bei denen ein oder mehrere Wasserstoffatome auch durch Halogen oder CN ersetzt sein können; dabei können auch Reste R³ bzw. R⁴ miteinander bzw. mit R¹ oder R² ein Ringsystem bilden;
n ist bei jedem Auftreten gleich oder verschieden eine ganze Zahl zwischen 0 und 30;
x ist bei jedem Auftreten gleich oder verschieden 0, 1, 2, 3, 4 oder 5;
mit der Maßgabe, dass die Anzahl dieser Gruppen gemäß Formel (1) bzw. Formel (2) durch die maximal verfügbaren H-Atome des organischen Halbleiters oder Leiters begrenzt ist; dabei wird durch die gestrichelte Bindung die Anknüpfung an den organischen Halbleiter angedeutet.

5. Verfahren gemäß Anspruch 4, **dadurch gekennzeichnet, dass** in dem organischen Halbleiter bzw. Leiter mindestens ein H-Atom durch eine Gruppe der Formel (1) gemäß Anspruch 4 ersetzt ist.

6. Verfahren gemäß einem oder mehreren der Ansprüche 1 bis 5, **dadurch gekennzeichnet, dass** der organische Halbleiter Ladungstransporteigenschaften und/oder Emissionseigenschaften und/oder Blockiereigenschaften aufweist.

7. Verfahren gemäß einem oder mehreren der Ansprüche 1 bis 6, **dadurch gekennzeichnet, dass** als Onium-Verbindung mindestens ein Diaryliodonium-, Diarylbromonium-, Diarylchloronium- oder Triarylsulfonium-Salz eingesetzt wird.

8. Verfahren gemäß einem oder mehreren der Ansprüche 1 bis 7, **dadurch gekennzeichnet, dass** der Anteil der Onium-Verbindung in der Mischung bzw. in der Schicht zwischen 0.01 und 5 Gew.% beträgt.

9. Verfahren gemäß Anspruch 8, **dadurch gekennzeichnet, dass** der Anteil der Onium-Verbindung in der Mischung bzw. in der Schicht zwischen 0.1 und 2 Gew.% beträgt.

10. Verfahren gemäß einem oder mehreren der Ansprüche 1 bis 9, **dadurch gekennzeichnet, dass** die Schicht nach der Bestrahlung nachbehandelt wird.

11. Verfahren gemäß Anspruch 10, **dadurch gekennzeichnet, dass** die Schicht nach der Bestrahlung getempert wird.

12. Verfahren gemäß Anspruch 11, **dadurch gekennzeichnet, dass** die Schicht in einem Temperaturbereich von 50 bis 250 °C getempert wird.

13. Verfahren gemäß Anspruch 10 und/oder 11, **dadurch gekennzeichnet, dass** die Schicht zwischen 0.1 und 10 Minuten getempert wird.

14. Verfahren gemäß einem oder mehreren der Ansprüche 10 bis 13, **dadurch gekennzeichnet, dass** die Schicht nach Bestrahlung und gegebenenfalls nach dem Tempern mit einem Lösemittel gespült wird.

15. Verfahren gemäß Anspruch 14, **dadurch gekennzeichnet, dass** dem Lösemittel mindestens ein Reduktionsmittel und/oder mindestens eine schwache Base bzw. ein Nucleophil zugefügt ist.

16. Verfahren gemäß einem oder mehreren der Ansprüche 1 bis 15, **dadurch gekennzeichnet, dass** mit einer Wellenlänge im Bereich von bis zu +/- 50 nm vom Absorptionsmaximum der jeweiligen Absorptionsbande des organischen Halbleiters bestrahlt wird.

17. Verfahren gemäß einem oder mehreren der Ansprüche 1 bis 16, **dadurch gekennzeichnet, dass** die Dauer der Bestrahlung zwischen 0.01 und 10 Sekunden bei einer Lichtintensität von < 1 mW/cm² liegt.

18. Organische Halbleiter enthaltend Gruppen gemäß Formel (3) und/oder Formel (4), 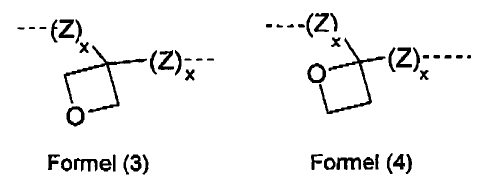 wobei die verwendeten Symbole und Indizes dieselbe Bedeutung haben, wie unter Anspruch 4 beschrieben.

19. Verfahren zur photosensibilisierten Dotierung organischer Halbleiter oder Leiter durch Photosäuren, **dadurch gekennzeichnet, dass** außerhalb der Absorptionsbande der Photosäure eingestrahlt wird.

## Claims

1. Process for crosslinking oxetane-functionalised, organic semiconductors and conductors, initiated by at least one added onium compound and by irradiation, **characterised in that** the irradiation is carried out at a wavelength at which the absorbance of the onium compound is at most 5% of the maximum absorbance.

2. Process according to Claim 1, **characterised in that** the irradiation is carried out at a wavelength at least 80 nm longer than the absorption maximum of the onium compound.

3. Process according to Claim 1 and/or 2, **characterised in that** the organic semiconductor or conductor is low-molecular-weight, oligomeric, dendritic or polymeric.

4. Process according to one or more of Claims 1 to 3, **characterised in that** at least one H atom in the organic semiconductor or conductor has been replaced by a group of the formula (1), formula (2), formula (3) or formula (4) 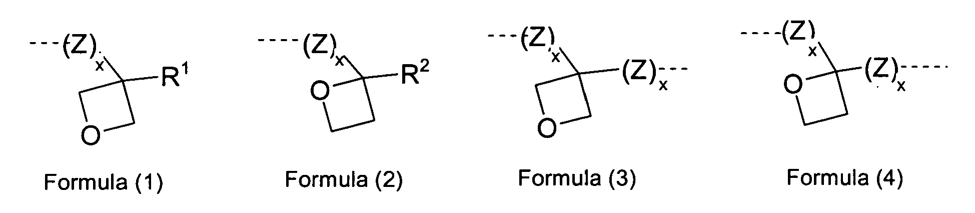 where the following applies to the symbols and indices used:
R¹ is on each occurrence, identically or differently, H, a straight-chain, branched or cyclic alkyl, alkoxyalkyl, alkoxy or thioalkoxy group having 1 to 20 C atoms, an aryl or heteroaryl group having 4 to 20 aromatic ring atoms or an alkenyl group having 2 to 10 C atoms, in which one or more hydrogen atoms may be replaced by halogen or CN and one or more non-adjacent C atoms may be replaced by -O-, -S-, -CO-, -COO- or -O-CO-;
R² is on each occurrence, identically or differently, H, a straight-chain, branched or cyclic alkyl or alkoxyalkyl group having 1 to 20 C atoms, an aryl or heteroaryl group having 4 to 20 aromatic ring atoms or an alkenyl group having 2 to 10 C atoms, in which one or more hydrogen atoms may be replaced by halogen or CN and one or more non-adjacent C atoms may be replaced by -O-, -S-, -CO-, -COO- or -O-CO-;
Z is on each occurrence, identically or differently, a divalent group -(CR³R⁴)ₙ-, in which, in addition, one or more non-adjacent C atoms may be replaced by -O-, -S-, -CO-, -COO- or -O-CO-, or a divalent aryl and/or N-, S- and/or O-heteroaryl group having 4 to 40 C atoms, which may also be substituted by one or more radicals R³;
R³, R⁴ are on each occurrence, identically or differently, H, a straight-chain, branched or cyclic alkyl, alkoxy, alkoxyalkyl or thioalkoxy group having 1 to 20 C atoms, an aryl or heteroaryl group having 4 to 20 aromatic ring atoms or an alkenyl group having 2 to 10 C atoms, in which one or more hydrogen atoms may also be replaced by halogen or CN; radicals R³ or R⁴ here may also form a ring system with one another or with R¹ or R²;
n is on each occurrence, identically or differently, an integer between 0 and 30;
x is on each occurrence, identically or differently, 0, 1, 2, 3, 4 or 5;
with the proviso that the number of these groups of the formula (1) or formula (2) is limited by the maximum number of available H atoms of the organic semiconductor or conductor; the dashed bond here indicates the link to the organic semiconductor.

5. Process according to Claim 4, **characterised in that** at least one H atom in the organic semiconductor or conductor has been replaced by a group of the formula (1) according to Claim 4.

6. Process according to one or more of Claims 1 to 5, **characterised in that** the organic semiconductor has charge-transport properties and/or emission properties and/or blocking properties.

7. Process according to one or more of Claims 1 to 6, **characterised in that** the onium compound employed is at least one diaryliodonium, diarylbromonium, diarylchloronium or triarylsulfonium salt.

8. Process according to one or more of Claims 1 to 7, **characterised in that** the proportion of the onium compound in the mixture or in the layer is between 0.01 and 5% by weight.

9. Process according to Claim 8, **characterised in that** the proportion of the onium compound in the mixture or in the layer is between 0.1 and 2% by weight.

10. Process according to one or more of Claims 1 to 9, **characterised in that** the layer is post-treated after the irradiation.

11. Process according to Claim 10, **characterised in that** the layer is conditioned after the irradiation.

12. Process according to Claim 11, **characterised in that** the layer is conditioned in a temperature range from 50 to 250°C.

13. Process according to Claim 10 and/or 11, **characterised in that** the layer is conditioned for between 0.1 and 10 minutes.

14. Process according to one or more of Claims 10 to 13, **characterised in that** the layer is rinsed with a solvent after irradiation and after any conditioning.

15. Process according to Claim 14, **characterised in that** at least one reducing agent and/or at least one weak base or a nucleophile has been added to the solvent.

16. Process according to one or more of Claims 1 to 15, **characterised in that** the irradiation is carried out at a wavelength in the region of up to +/- 50 nm of the absorption maximum of the respective absorption band of the organic semiconductor.

17. Process according to one or more of Claims 1 to 16, **characterised in that** the duration of the irradiation is between 0.01 and 10 seconds at a light intensity of < 1 mW/cm².

18. Organic semiconductor containing groups of the formula (3) and/or formula (4) 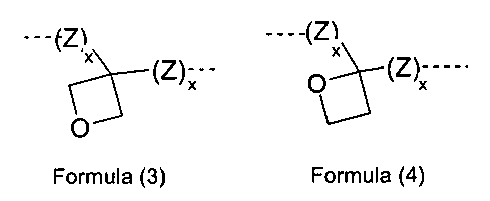 where the symbols and indices used have the same meaning as described under Claim 4.

19. Process for the photosensitised doping of organic semiconductors or conductors by photoacids, **characterised in that** the irradiation is carried out outside the absorption band of the photoacid.

## Revendications

1. Procédé pour réticuler des semiconducteurs et des conducteurs organiques fonctionnalisés par oxétane, initié au moyen d'au moins un composé onium ajouté et au moyen d'une irradiation, **caractérisé en ce que** l'irradiation est mise en oeuvre à une longueur d'onde à laquelle l'absorbance du composé onium est d'au plus 5% de l'absorbance maximum.

2. Procédé selon la revendication 1, **caractérisé en ce que** l'irradiation est mise en oeuvre à une longueur d'onde d'au moins 80 nm plus longue que le maximum d'absorption du composé onium.

3. Procédé selon les revendications 1 et/ou 2, **caractérisé en ce que** le semiconducteur ou le conducteur organique est de poids moléculaire faible, oligomérique, dendritique ou polymérique.

4. Procédé selon une ou plusieurs des revendications 1 à 3, **caractérisé en ce qu'**au moins un atome de H dans le semiconducteur ou le conducteur organique a été remplacé par un groupe de la formule (1), de la formule (2), de la formule (3) ou de la formule (4) 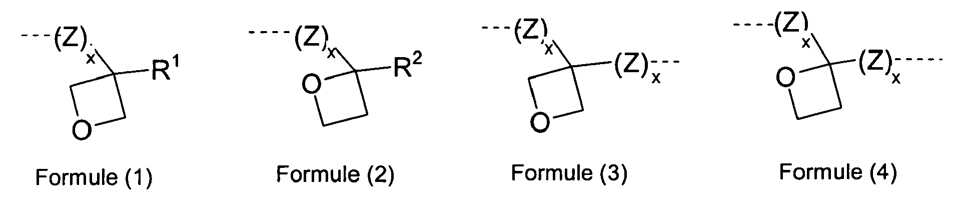 dans lesquelles ce qui suit s'applique aux symboles et indices utilisés :
R¹ est, lors de chaque occurrence, de manière identique ou différente, H, un groupe alkyle, alcoxyalkyle, alcoxy ou thioalcoxy en chaîne droite, ramifié ou cyclique comportant de 1 à 20 atomes de C, un groupe aryle ou hétéroaryle comportant de 4 à 20 atomes de cycle aromatique ou un groupe alkényle comportant de 2 à 10 atomes de C où un ou plusieurs atomes d'hydrogène peuvent être remplacés par halogène ou CN et un ou plusieurs atomes de C non adjacents peuvent être remplacés par -O-, -S-, -CO-, -COO- ou -O-CO-;
R² est, lors de chaque occurrence, de manière identique ou différente, H, un groupe alkyle ou alcoxyalkyle en chaîne droite, ramifié ou cyclique comportant de 1 à 20 atomes de C, un groupe aryle ou hétéroaryle comportant de 4 à 20 atomes de cycle aromatique ou un groupe alkényle comportant de 2 à 10 atomes de C, où un ou plusieurs atomes d'hydrogène peuvent être remplacés par halogène ou CN et un ou plusieurs atomes de C non adjacents peuvent être remplacés par -O-, -S-, -CO-, -COO- ou -O-CO-;
Z est, lors de chaque occurrence, de manière identique ou différente, un groupe divalent -(CR³R⁴)ₙ- où, en plus, un ou plusieurs atomes de C non adjacents peuvent être remplacés par -O-, -S-, -CO-, -COO- ou -O-CO-, ou un groupe aryle divalent et/ou N-, S- et/ou O-hétéroaryle comportant de 4 à 40 atomes de C, qui peuvent également être substitués par un ou plusieurs radicaux R³ ;
R³, R⁴ sont, lors de chaque occurrence, de manière identique ou différente, H, un groupe alkyle, alcoxy, alcoxyalkyle ou thioalcoxy en chaîne droite, ramifié ou cyclique comportant de 1 à 20 atomes de C, un groupe aryle ou hérétoaryle comportant de 4 à 20 atomes de cycle aromatique ou un groupe alkényle comportant de 2 à 10 atomes de C, où un ou plusieurs atomes d'hydrogène peuvent également être remplacés par halogène ou CN ; les radicaux R³ ou R⁴ peuvent également ici former un système de cycles les uns avec les autres ou avec R¹ ou R² ;
n est, lors de chaque occurrence, de manière identique ou différente, un entier entre 0 et 30 ;
x est, lors de chaque occurrence, de manière identique ou différente, 0, 1, 2, 3, 4 ou 5 ;
étant entendu que le nombre des groupes de la formule (1) ou de la formule (2) est limité par le nombre maximum d'atomes de H disponibles du semiconducteur ou du conducteur organique ; la liaison en pointillés indique ici la liaison sur le semiconducteur organique.

5. Procédé selon la revendication 4, **caractérisé en ce qu'**au moins un atome de H dans le semiconducteur ou le conducteur organique a été remplacé par un groupe de la formule (1) selon la revendication 4.

6. Procédé selon une ou plusieurs des revendications 1 à 5, **caractérisé en ce que** le semiconducteur organique présente des propriétés de transport de charge et/ou des propriétés d'émission et/ou des propriétés de blocage.

7. Procédé selon une ou plusieurs des revendications 1 à 6, **caractérisé en ce que** le composé onium utilisé est au moins un sel pris parmi un sel de diaryliodonium, de diarylbromonium, de diarylchloronium et de triarylsulfonium.

8. Procédé selon une ou plusieurs des revendications 1 à 7, **caractérisé en ce que** la proportion du composé onium dans le mélange ou dans la couche est entre 0,01 % et 5% en poids.

9. Procédé selon la revendication 8, **caractérisé en ce que** la proportion du composé onium dans le mélange ou dans la couche est entre 0,1 % et 2% en poids.

10. Procédé selon une ou plusieurs des revendications 1 à 9, **caractérisé en ce que** la couche est post-traitée après l'irradiation.

11. Procédé selon la revendication 10, **caractérisé en ce que** la couche est conditionnée après l'irradiation.

12. Procédé selon la revendication 11, **caractérisé en ce que** la couche est conditionnée dans une plage de températures de 50°C à 250°C.

13. Procédé selon les revendications 10 et/ou 11, **caractérisé en ce que** la couche est conditionnée pendant entre 0,1 minute et 10 minutes.

14. Procédé selon une ou plusieurs des revendications 10 à 13, **caractérisé en ce que** la couche est rincée à l'aide d'un solvant après l'irradiation et après un quelconque conditionnement.

15. Procédé selon la revendication 14, **caractérisé en ce qu'**au moins un agent réducteur et/ou au moins une base faible ou un nucléophile a été ajouté au solvant.

16. Procédé selon une ou plusieurs des revendications 1 à 15, **caractérisé en ce que** l'irradiation est mise en oeuvre à une longueur d'onde dans la région qui va jusqu'à +/- 50 nm du maximum d'absorption de la bande d'absorption respective du semiconducteur organique.

17. Procédé selon une ou plusieurs des revendications 1 à 16, **caractérisé en ce que** la durée de l'irradiation est entre 0,01 seconde et 10 secondes à une intensité lumineuse < 1 mW/cm².

18. Semiconducteur organique contenant des groupes de la formule (3) et/ou de la formule (4) 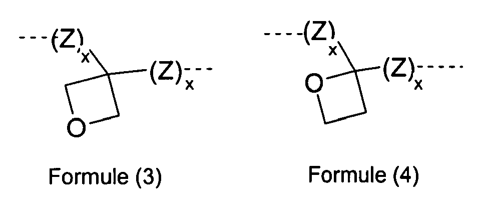 dans lesquelles les symboles et indices utilisés présentent la même signification que décrit selon la revendication 4.

19. Procédé pour le dopage photosensibilisé de semiconducteurs ou de conducteurs organiques au moyen de photoacides, **caractérisé en ce que** l'irradiation est mise en oeuvre à l'extérieur de la bande d'absorption du photoacide.
